# EUROPÄISCHE PATENTANMELDUNG

(11) **EP 3 324 451 A1**
(43) Veröffentlichungstag der Anmeldung: **23.05.2018**
(21) Anmeldenummer: 17001883.2
(22) Anmeldetag: 17.11.2017
(51) Int. Cl.: H01L 31/0687, H01L 31/0304, H01L 31/18

(54) **STAPELFÖRMIGE HALBLEITERSTRUKTUR**

(30) Priorität: 18.11.2016 DE 102016013749
(71) Anmelder: AZUR SPACE Solar Power GmbH, 74072 Heilbronn (DE)
(72) Erfinder: Fuhrmann, Daniel, 74081 Heilbronn (DE); Guter, Wolfgang, 70190 Stuttgart (DE); Khorenko, Victor, 74196 Neuenstadt a.K. (DE)
(74) Vertreter: Koch Müller Patentanwaltsgesellschaft mbH

(57) **Zusammenfassung**

Stapelförmige Halbleiterstruktur (HL) aufweisend eine Anzahl N zueinander in Serie geschaltete Halbleiterdioden, wobei jede Halbleiterdiode (D1, D2, D3, D4, D5) einen p-n Übergang aufweist, und zwischen jeweils zwei aufeinanderfolgenden Halbleiterdioden (D1, D2, D3, D4, D5) eine Tunneldiode (T1, T2; T3, T4) ausgebildet ist, und die Halbleiterdioden (D1, D2, D3, D4, D5) und die Tunneldioden (T1, T2, T3, T4) zusammen monolithisch integriert sind, und gemeinsam einen Stapel (ST1) mit einer Oberseite und einer Unterseite ausbilden, und die Anzahl N der Halbleiterdiode (D1, D2, D3, D4, D5) größer gleich zwei ist, und bei einer Beleuchtung des Stapels (ST1) mit Licht (L) der Stapel (ST1) bei 300 K eine Quellenspannung (VQ1) von größer als 2 Volt aufweist, und von der Oberseite des ersten Stapels (ST1) hin zu der Unterseite des Stapels die Gesamtdicke der p und n -Absorptionsschichten einer Halbleiterdiode von der obersten Diode (D1) hin zu der untersten Diode (D3 - D5) zunimmt, und die Halbleiterdioden (D1, D2, D3, D4, D5) die gleiche Bandlücke aufweisen, und der Stapel (ST1) auf einem Substrat ausgebildet ist, und in der Nähe der Unterseite des Stapels (ST1) eine umlaufende, absatzförmigen Hauptstufe mit einer Auftrittsfläche (STU) ausgebildet ist, und die Seitenfläche der Halbleiterschichten mittels eines Ätzprozesses ausgebildet sind und einen Mittenrauwert Ra zwischen 0,002 µm und 0,2 µm aufweist und der Stapel mit der Unterseite auf einem Substrat (SUB) angeordnet ist und das Substrat (SUB) ein Halbleitermaterial umfasst.

## Beschreibung

Die Erfindung betrifft eine stapelförmige Halbleiterstruktur.

Aus der US 4 127 862 sind stapelförmige Halbleiterstrukturen aus III-V Materialien bekannt.

Vor diesem Hintergrund besteht die Aufgabe der Erfindung darin, eine Vorrichtung anzugeben, die den Stand der Technik weiterbildet.

Die Aufgabe wird durch eine stapelförmige Halbleiterstruktur mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige Halbleiterstruktur bereitgestellt, aufweisend eine Anzahl N zueinander in Serie geschaltete Halbleiterdioden.

Jede Halbleiterdiode weist einen p-n Übergang und eine p-dotierte Absorptionsschicht und eine n-Absorptionsschicht auf, wobei die n-Absorptionsschicht von einer n-dotierten Passivierungsschicht mit einer größeren Bandlücke als die Bandlücke der n-Absorptionsschicht passiviert ist. Jede p-Absorptionsschicht der Halbleiterdiode ist von einer p-dotierten Passivierungsschicht mit einer größeren Bandlücke als die Bandlücke der p-Absorptionsschicht passiviert.

Zwischen jeweils zwei aufeinanderfolgenden Halbleiterdioden ist eine Tunneldiode ausgebildet, wobei die Tunneldiode mehrere Halbleiterschichten mit einer höheren Bandlücke als die Bandlücke der p / n Absorptionsschichten aufweist und die Halbleiterschichten mit der höheren Bandlücke jeweils aus einem Material mit geänderter Stöchiometrie und / oder anderer Elementzusammensetzung als die p / n -Absorptionsschichten der Halbleiterdiode bestehen.

Die Halbleiterdiode und die Tunneldioden sind zusammen monolithisch integriert und bilden gemeinsam einen Stapel mit einer Oberseite und einer Unterseite aus.

Die Anzahl N der Halbleiterdioden ist größer gleich zwei. Bei einer Beleuchtung des Stapels mit Licht weist der Stapel bei 300 K eine Quellenspannung von größer als 2 Volt auf.

Das Licht trifft an der Oberseite auf die Oberfläche auf den Stapel auf. Die Größe der beleuchteten Oberfläche an der Stapeloberseite entspricht im Wesentlichen der Größe der Fläche des Stapels an dessen Oberseite.

In Lichteinfallsrichtung ausgehend von der Oberseite des Stapels hin zu der Unterseite des Stapels nimmt die Gesamtdicke der p und n - Absorptionsschichten der Halbleiterdiode von der obersten Diode hin zu der untersten Diode zu.

Die Halbleiterdioden weisen die gleiche Bandlücke oder einen Unterschied in der Bandlücke von kleiner 0,1 eV auf. Die Gesamtdicke des Stapels ist kleiner als 20 µm. Der Stapel ist auf einem Substrat angeordnet.

In der Nähe der Unterseite des Stapels ist eine umlaufende, absatzförmige Hauptstufe mit einer Auftrittsfläche ausgebildet. Die Kante der Hauptstufe liegt um wenigstens 5 µm und um maximal 500 µm von der unmittelbar angrenzenden Seitenfläche des Stapels entfernt.

Die Seitenfläche der Halbleiterschichten sind mittels eines Ätzprozesses ausgebildet und weisen einen Mittenrauwert Ra zwischen 0,002 µm und 0,2 µm auf.

Der mit der Unterseite auf einem Substrat angeordnete Stapel und das Substrat umfassen oder bestehen jeweils aus einem Halbleitermaterial.

Es sei angemerkt, dass mit dem Ausdruck "entspricht im Wesentlichen" in Zusammenhang des Vergleichs der Beleuchtungsfläche an der Stapeloberseite mit der Größe der Fläche des ersten Stapels an der Oberseite verstanden wird, einen Unterschied in der Fläche insbesondere kleiner als 20% oder vorzugsweise kleiner als 10% oder vorzugsweise kleiner als 5% oder höchst vorzugsweise die beiden Flächen gleich sind. Anders ausgedrückt ist die nichtbeleuchtete Fläche auf der Stapeloberseite kleiner als 20% oder vorzugsweise kleiner als 10% oder vorzugsweise kleiner als 5% der Größe der Fläche des ersten Stapels an der Oberseite.

Auch sei angemerkt, dass mit dem Ausdruck "Licht" zur Bestrahlung der Stapeloberseite, ein Licht verstanden wird, welches ein Spektrum an Wellenlängen in dem Bereich der Absorption der Absorptionsschichten aufweist. Es versteht sich, dass auch ein monochromatisches Licht beispielsweise durch die Beleuchtung mit einer Leuchtdiode oder einer Laserdiode als Beleuchtungsquelle, welches eine bestimmte d.h. absorbierende Wellenlänge aufweist, also eine Wellenlänge in dem Bereich der Absorption der Absorptionsschichten, geeignet ist.

Es versteht sich, dass die vorzugsweise die gesamte Oberseite des ersten Stapels d.h. die gesamte oder nahezu die gesamte Oberfläche mit Licht einer bestimmten Wellenlänge bestrahlt wird. Es sei angemerkt, dass eingehende Untersuchungen in überraschender Weise zeigten, dass im Unterschied zu dem Stand der Technik sich in vorteilhafter Weise mit dem vorliegenden monolithischen Stapelansatz Quellenspannungen oberhalb von 2V ergeben.

Ein Vorteil der erfindungsgemäßen Vorrichtung ist es, dass durch das Ätzen und die Ausbildung einer umlaufenden Stufe sich die Halbleiterstrukturen zuverlässig und kostengünstig vereinzeln lassen. Ein Sägeprozess, zum durchtrennen des Substrates wird erst nach dem Ätzprozess durchgeführt. Keinesfalls werden die Seitenflächen des Stapels durch den Sägeprozess überformt.

Anders ausgedrückt, nach Ausbildung eines umlaufenden Grabens unter Anwendung eines Maskenschrittes und die Ausbildung der Stapel werden mittels der Säge die Stapel vereinzelt. Es versteht sich, dass sich um jeden einzelnen Stapel sich eine umlaufende Hauptstufe ausbildet.

Eine negative Beeinflussung der elektrischen Eigenschaften durch das Auseinandersägen der einzelnen Strukturen wird reduziert oder ganz vermieden. Das Ätzen lässt sich sowohl nasschemisch als auch mittels eines RIE Prozesses, d.h. einem Trockenätzprozess oder mittels einer Kombination durchführen.

Es versteht sich, dass die Ätzprozesse eine möglichst hohe Anisotropie aufweisen, d.h. die Ätzrate senkrecht zur Oberfläche des Stapels ist wesentlich größer als die Ätzrate in Richtung der Oberfläche. Unter wesentlich größer wird vorliegend mindestens einen Faktor 2, vorzuweise mindestens einen Faktor 10 und höchst vorzugsweise mindestens einen Faktor 100 verstanden. Vorzugsweise stoppt die Ätzung in dem Substrat oder auf dem Substrat.

Ein weiterer Vorteil ist, dass mittels der stapelförmigen Anordnung von den Dioden im Vergleich zu der bisherigen lateralen Anordnung mit Siliziumdioden eine große Flächeneinsparung ergibt. Insbesondere muss nur die wesentlich kleinere Empfangsfläche des Stapels beleuchtet werden.

In einer Weiterbildung ist zwischen dem Substrat und der Unterseite des Stapels eine Zwischenschicht angeordnet, um einen monolithischen Verbund zwischen der Unterseite des Stapel und der Oberseite des Substrats zu erzielen. Die Zwischenschicht umfasst eine Nukleationsschicht und / oder eine Pufferschicht.

In einer anderen Weiterbildung ist die Auftrittsfläche der Hauptstufe an der Oberseite des Substrats oder in dem Substrat oder auf der Oberseite der Zwischenschicht oder in der Zwischenschicht ausgebildet.

In einer Ausführungsform liegt die Normale der Seitenfläche des Stapels im Vergleich zu der Normale der Auftrittsfläche in einen Winkelbereich zwischen 75° und 115° oder zwischen einem Winkelbereich zwischen 95° und 105° liegt. Anders ausgedrückt die Seitenfläche des Stapels steht entweder genau senkrecht, d.h. 90° auf der Auftrittsfläche oder ist in einem Winkelbereich von ± 15 ° oder ± 5° geneigt.

In einer anderen Weiterbildung ist die Auftrittsfläche plan ausgebildet und / oder die Auftrittsfläche weist umlaufend einen Tiefenunterschied von kleiner als einen Faktor 4 oder keinen Unterschied in der Tiefe auf. Anders ausgedrückt ist die Außenkante, sofern die Auftrittsfläche der Hauptstufe keinen Unterschied in der Tiefe aufweist, umlaufend gleich weit von der Seitenfläche des Stapels entfernt. Die Tiefe der Stufe ist also nichts anders als die Entfernung zwischen der Außenkante der Hauptstufe und der Seitenfläche.

In einer Ausführungsform sind an der Seitenfläche des Stapels zwischen zwei unmittelbar aufeinanderfolgenden Halbleiterschichten Nebenstufen mit einer Stufentiefe kleiner als 5 µm ausgebildet sind. Vorzugsweise beträgt die Tiefe der Nebenstufe weniger als 1 µm oder weniger als 0,2 µm. Es versteht sich, dass je geringer die Tiefe der Nebenstufen sind, die Seitenflächen umso ebener ausgebildet sind und sich auch einfacher und zuverlässiger passivieren lassen. Höchst vorzugsweise beträgt die Mindesttiefe der Nebenstufe mehr als 0,01 µm.

In einer Weiterbildung weicht die Teilquellenspannung der einzelnen Teilspannungsquellen untereinander weniger als 10% ab. Hierdurch lässt sich die Halbleiterstruktur als skalierbare Spannungsquelle verwenden. Es versteht sich, dass sich der Begriff der "Skalierbarkeit" auf die Höhe der Quellenspannung des gesamten Stapels bezieht.

In einer anderen Weiterbildung weisen die Halbleiterdioden jeweils das gleiche Halbleitermaterial auf, wobei hierbei das Halbleitermaterial der Dioden die gleiche kristalline Zusammensetzung aufweist und vorzugsweise die Stöchiometrie nahezu oder vorzugsweise genau gleich ist.

In einer anderen Ausführungsform bestehen die Halbleiterdioden aus dem gleichen Material wie das Substrat. Ein Vorteil ist, dass sich dann insbesondere die Ausdehnungskoeffizienten der beiden Teile gleichen. Es ist vorteilhaft, wenn die Halbleiterdioden grundsätzlich aus einem III-V Material bestehen. Insbesondere Ist es bevorzugt, GaAs zu verwenden.

In einer Ausführungsform besteht das Halbleitermaterial und / oder das Substrat aus III-V Materialien. Insbesondere ist auch bevorzugt, dass das Substrat Germanium oder Galliumarsenid umfasst und / oder die Halbleiterschichten auf dem Substrat Arsen und / oder Phosphor aufweisen.

Anders ausgedrückt, umfassen die Halbleiterschichten As-haltige Schichten und P -haltige Schichten, d.h. Schichten aus GaAs oder AlGaAs oder InGaAs als Beispiele für Arsenid-Schichten und InGaP als ein Beispiel für Phosphid-Schichten.

Des Weiteren ist es bevorzugt, dass der erste Stapel eine Grundfläche kleiner als 4 mm² oder kleiner als 1 mm² aufweist. Untersuchungen haben gezeigt, dass es vorteilhaft ist, die Grundfläche viereckig oder kreisförmig, insbesondere rund auszubilden. Vorzugsweise ist die Grundfläche des Stapels quadratisch oder als Kreis oder als Ellipse ausgebildet.

In einer bevorzugten Ausführungsform ist auf der Oberseite des ersten Stapels ein erster Anschlusskontakt als ein umlaufender Metallkontakt in der Nähe des Randes oder als einzelne Kontaktfläche an dem Rand ausgebildet.

Es ist bevorzugt, auf der Unterseite des ersten Stapels einen zweiten Anschlusskontakt auszubilden und insbesondere, dass der zweite Anschlusskontakt flächig ausgebildet ist oder vorzugsweise an der gesamten Unterseite des Substrates ausgebildet ist.

Des Weiteren ist es bevorzugt, dass unterhalb der untersten Halbleiterdiode des Stapels ein Halbleiterspiegel ausgebildet ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: ein elektrotechnisches Ersatzschaltbild eines Stapels ST1 einer erfindungsgemäßen Halbleiterstruktur HL,
- Figur 2: eine Querschnittsansicht einer Halbleiterstruktur HL,
- Figur 3: eine perspektivische Ansicht einer Halbleiterstruktur HL,
- Figur 4a - e: eine detaillierte Querschnittsansicht auf die Ätztiefe für die Ausbildung der umlaufenden Stufe in Bezug auf die Ätztiefe.

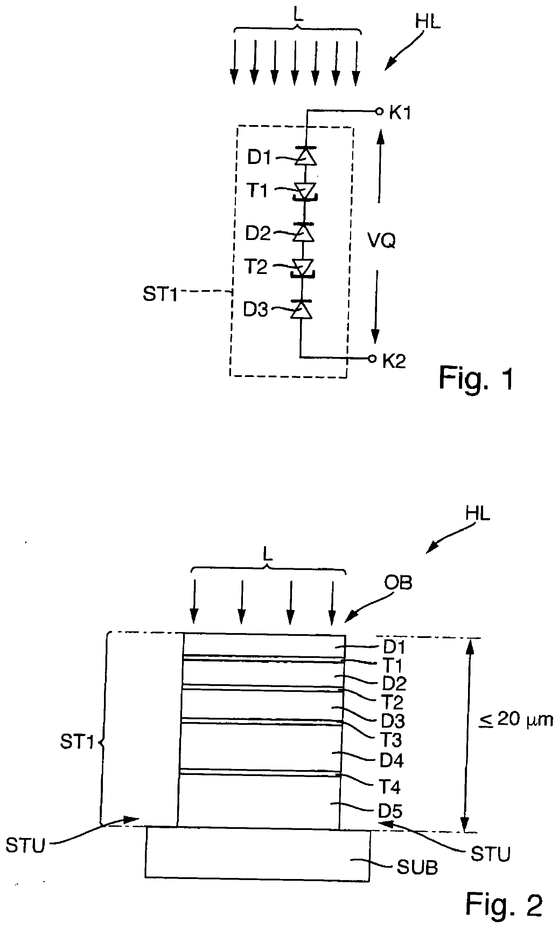

Die Abbildung der Figur 1 zeigt ein elektrotechnisches Ersatzschaltbild eines Stapels ST1 einer erfindungsgemäßen Halbleiterstruktur HL.

Die Halbleiterstruktur HL umfasst einen Stapel ST1 mit einer Oberseite und einer Unterseite mit einer Anzahl N gleich drei Dioden. Der Stapel ST1 weist eine Serienschaltung aus einer ersten Diode D1 und einer ersten Tunneldiode T1 und einer zweiten Diode D2 und einer zweiten Tunneldiode T2 und einer dritten Diode D3 auf. An der Oberseite des Stapel ST1 ist ein erster Anschlusskontakt K1 und der Unterseite des Stapel ST1 ein zweiter Anschlusskontakt K2 ausgebildet. Die Quellenspannung VQ1 des Stapels ST1 setzt sich vorliegend aus den Teilspannungen der einzelnen Dioden D1 bis D3 zusammen. Hierzu ist der erste Stapel ST1 einem Photonenstrom, d.h. dem Licht L ausgesetzt.

Der Stapel ST1 der Dioden D1 bis D3 und der Tunneldioden T1 und T2 ist als monolithisch ausgebildeter Block, vorzugsweise aus dem gleichen Halbleitermaterial, ausgeführt.

In der Abbildung der Figur 2 ist eine Querschnittsansicht einer Halbleiterstruktur HL dargestellt. Im Folgenden werden nur die Unterschiede zu der Abbildung der Figur 1 erläutert. Die Halbleiterstruktur HL umfasst den Stapel ST1 und einem unter dem Stapel ST1 ausgebildeten Halbleitersubstrat.

Der erste Stapel ST1 umfasst insgesamt fünf in Reihe geschaltete Dioden D1 bis D5. Auf die Oberfläche OB der ersten Diode D1, die vorliegend auch die Oberseite des Stapels ST1 ausbildet, trifft das Licht L auf. Die Oberfläche OB wird nahezu oder vollständig ausgeleuchtet. Zwischen den Dioden D1-D5 ist jeweils eine Tunneldiode T1-T4 ausgebildet.

Mit zunehmender Entfernung der einzelnen Diode D1 bis D5 von der Oberfläche OB steigt die Dicke des Absorptionsgebiets, so dass die unterste Diode D5 das dickste Absorptionsgebiet aufweist. Insgesamt beträgt die Gesamtdicke des ersten Stapels ST1 kleiner gleich 20 µm.

Unterhalb der untersten Diode D5, die vorliegend auch die Unterseite des Stapels ST1 ausbildet, ist das Substrat SUB ausgebildet. Die laterale Ausdehnung des Substrats SUB ist größer als die laterale Ausdehnung des Stapels an der dessen Unterseite, so dass sich eine umlaufende Hauptstufe STU ausbildet.

Die Hauptstufe STU, ist monolithisch mit dem Stapel verbunden. Um den Stapel auszubilden wird nach der ganzflächigen, vorzugsweise epitaktischen Herstellung aller Schichten der Halbleiterstruktur HL, eine Ätzung bis zum Substrat durchgeführt.

Hierzu wird mittels eines Maskenprozesses eine Lackmaske erzeugt und anschließend eine nasschemische Ätzung zur Erzeugung der Gräben durchgeführt. Die Ätzung stoppt in dem Substrat oder auf dem Substrat oder in einer zwischen dem Substrat und der Stapelunterseite ausgebildeten Zwischenschicht.

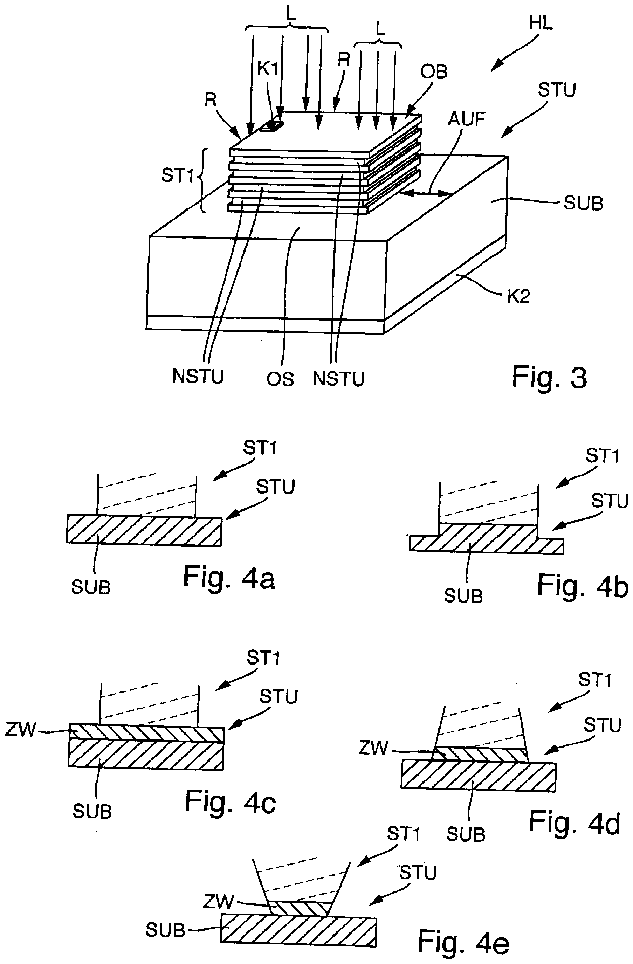

In der Abbildung der Figur 3 ist eine perspektivische Ansicht einer Halbleiterstruktur HL dargestellt. Im Folgenden werden nur die Unterschiede zu den Ausführungsformen, dargestellt in den vorangegangenen Figuren, erläutert.

Auf der Oberfläche des Stapels ST1 ist an dem Rand R ein erster metallischer Anschlusskontakt K1 ausgebildet. Das Substrat SUB weist an der Oberseite eine Auftrittsfläche AUF der Hauptstufe STU auf.

Der Stapel ST1 weist eine quadratische Grundfläche mit vier senkrechten Seitenflächen aus. Indem die einzelnen Halbleiterschichten des Stapels ST1 etwas unterschiedliche laterale Ätzraten aufweisen, bilden sich entlang der senkrechten Richtung der Seitenflächen eine Vielzahl von Nebenstufen NSTU mit einer geringen Stufentiefe.

Die Oberseite des Substrats SUB ist stoffschlüssig mit der untersten, d.h. der fünften Diode D5 verbunden.

In einer erst später dargestellten Ausführungsform ist auf dem Substrat SUB eine Zwischenschicht, aufweisend eine dünne Nukleationsschicht und / oder eine Pufferschicht ausgebildet, d.h. die Unterseite des Stapel ST1 ist stoffschlüssig mit der Zwischenschicht verbunden.

Die Oberseite OS des Substrats SUB weist eine größere Oberfläche als die Fläche an der Unterseite des Stapels ST1 auf. Hierdurch bildet sich die umlaufende Hauptstufe STU aus. Der Rand der Hauptstufe STU ist von der unmittelbar angrenzenden Seitenfläche des ersten Stapels ST1 der Hauptstufe um mehr als 5 µm und weniger als 500 µm entfernt, dargestellt als Tiefe der Auftrittsfläche AUF.

An der Unterseite des Substrats SUB ist ein zweiter ganzflächiger metallischer Anschlusskontakt K2 ausgebildet.

Die Abbildung der Figur 4a - e zeigen detaillierte Querschnittsansichten auf verschiedene Ausführungsformen für die Ausbildung der umlaufenden Hauptstufe in Bezug auf die Ätztiefe. Die Seitenflächen des Stapels ST1 sind hinsichtlich der Höhe nur teilweise dargestellt.

In der Abbildung der Figur 4a ist die Hauptstufe STU an der Grenzfläche Substrat SUB und Unterseite des Stapels ST1 ausgebildet. Eine Zwischenschicht ZW zwischen dem Substrat SUB und dem ersten Stapel ST1 ist nicht vorhanden, d.h. das Substrat SUB ist stoffschlüssig mit der Unterseite des Stapels ST1 verbunden. Anders ausgedrückt der Ätzprozess war sehr selektiv und anisotrop und stoppte auf dem Material des Substrates SUB.

In der Abbildung der Figur 4b ist die Hauptstufe STU in dem Substrat SUB ausgebildet. Der Ätzprozess war nicht oder nur wenig selektiv zwischen den Schichten des Staels ST1 und dem Material des Substrates SUB.

In einer nicht dargestellten Ausführungsform ist die Hauptstufe STU in dem Substrat SUB ausgebildet und das Substrat SUB ist stoffschlüssig mit der Unterseite der Zwischenschicht ZW und die Unterseite des Stapels ST1 ist stoffschlüssig mit der Oberseite der Zwischenschicht ZW verbunden.

In der Abbildung der Figur 4c ist die Hauptstufe STU an der Grenzfläche Zwischenschicht ZW und Unterseite des Stapels ST1 ausgebildet. Die Zwischenschicht ZW zwischen dem Substrat SUB und dem erstens Stapel ST1 ist ausgebildet, d.h. das Substrat SUB ist stoffschlüssig mit der Unterseite der Zwischenschicht ZW und die Unterseite des Stapels ST1 ist stoffschlüssig mit der Oberseite der Zwischenschicht ZW verbunden. Anders ausgedrückt der Ätzprozess war sehr selektiv und anisotrop und stoppte auf dem Material der Zwischenschicht ZW.

In der Abbildung der Figur 4d ist die Hauptstufe STU an der Grenzfläche Substrat SUB und Unterseite der Zwischenschicht ZW ausgebildet. Die Seitenflächen des Stapels sind gegeneinander geneigt und bilden zu der Oberfläche des Substrats einen Winkel größer als 90° aus.

Die Zwischenschicht ZW zwischen dem Substrat SUB und dem erstens Stapel ST1 ist ausgebildet, d.h. das Substrat SUB ist stoffschlüssig mit der Unterseite der Zwischenschicht ZW und die Unterseite des Stapels ST1 ist stoffschlüssig mit der Oberseite der Zwischenschicht ZW verbunden. Die Zwischenschicht ist oberhalb der Auftrittsfläche AUF der Hauptstufe vollständig oder nahezu vollständig entfernt. Anders ausgedrückt der Ätzprozess war sehr selektiv und anisotrop und stoppte auf dem Substrat SUB.

In der Abbildung der Figur 4e ist die Hauptstufe STU an der Grenzfläche Substrat SUB und Unterseite der Zwischenschicht ZW ausgebildet. Die Seitenflächen des Stapels sind von einander weg geneigt und bilden zu der Oberfläche des Substrats einen Winkel kleiner als 90° aus.

Die Zwischenschicht ZW zwischen dem Substrat SUB und dem erstens Stapel ST1 ist ausgebildet, d.h. das Substrat SUB ist stoffschlüssig mit der Unterseite der Zwischenschicht ZW und die Unterseite des Stapels ST1 ist stoffschlüssig mit der Oberseite der Zwischenschicht ZW verbunden. Die Zwischenschicht ist oberhalb der Auftrittsfläche AUF der Hauptstufe vollständig oder nahezu vollständig entfernt. Anders ausgedrückt der Ätzprozess war sehr selektiv und anisotrop und stoppte auf dem Substrat SUB.

## Patentansprüche

1. Stapelförmige Halbleiterstruktur (HL) aufweisend
- eine Anzahl N zueinander in Serie geschaltete Halbleiterdioden, wobei jede Halbleiterdiode (D1, D2, D3, D4, D5) einen p-n Übergang aufweist, und die Halbleiterdiode (D1, D2, D3, D4, D5) eine p-dotierte Absorptionsschicht aufweist und die Halbleiterdiode (D1, D2, D3, D4, D5) eine n-Absorptionsschicht aufweist, wobei die n-Absorptionsschicht von einer n-dotierten Passivierungsschicht mit einer größeren Bandlücke als die Bandlücke der n-Absorptionsschicht passiviert ist, und wobei die p-Absorptionsschicht der Halbleiterdiode von einer p-dotierten Passivierungsschicht mit einer größeren Bandlücke als die Bandlücke der p-Absorptionsschicht passiviert ist, und
- zwischen jeweils zwei aufeinanderfolgenden Halbleiterdioden (D1, D2, D3, D4, D5) eine Tunneldiode (T1, T2; T3, T4) ausgebildet ist, wobei die Tunneldiode (T1, T2, T3, T4) mehrere Halbleiterschichten mit einer höheren Bandlücke als die Bandlücke der p / n Absorptionsschichten aufweist und die Halbleiterschichten mit der höheren Bandlücke jeweils aus einem Material mit geänderter Stöchiometrie und / oder anderer Elementzusammensetzung als die p / n -Absorptionsschichten der Halbleiterdiode (D1, D2, D3, D4, D5) bestehen, und
- die Halbleiterdiode (D1, D2, D3, D4, D5) und die Tunneldioden (T1, T2, T3, T4) zusammen monolithisch integriert sind, und gemeinsam einen Stapel (ST1) mit einer Oberseite und einer Unterseite ausbilden, und die Anzahl N der Halbleiterdiode (D1, D2, D3, D4, D5) größer gleich zwei ist, und
- bei einer Beleuchtung des Stapels (ST1) mit Licht (L) der Stapel (ST1) bei 300 K eine Quellenspannung (VQ) von größer als 2 Volt aufweist, wobei das Licht (L) an der Oberseite auf die Oberfläche (OB) auf den Stapel (ST1) auftrifft,
**dadurch gekennzeichnet, dass**
die Größe der beleuchteten Oberfläche an der Stapeloberseite im Wesentlichen der Größe der Fläche des Stapels (ST1) an der Oberseite entspricht, und
- in Lichteinfallsrichtung von der Oberseite des Stapels (ST1) hin zu der Unterseite des Stapels (ST1) die Gesamtdicke der p und n - Absorptionsschichten einer Halbleiterdiode von der obersten Diode (D1) hin zu der untersten Diode (D3 - D5) zunimmt, und
die Halbleiterdioden (D1, D2, D3, D4, D5) die gleiche Bandlücke oder einen Unterschied in der Bandlücke von kleiner 0,1 eV aufweisen, und
- der Stapel (ST1) eine Gesamtdicke kleiner als 20 µm aufweist und auf einem Substrat (SUB) ausgebildet ist, und
in der Nähe der Unterseite des Stapels (ST1) eine umlaufende, absatzförmige Hauptstufe mit einer Auftrittsfläche (AUF) ausgebildet ist, wobei die Kante der Hauptstufe (STU) um wenigstens 5 µm und um maximal 500 µm von der unmittelbar angrenzenden Seitenfläche des Stapels (ST1) entfernt ist, und
die Seitenflächen der Halbleiterschichten die den Stapel (ST1) bilden mittels eines Ätzprozesses ausgebildet sind und einen Mittenrauwert Ra zwischen 0,002 µm und 0,2 µm aufweisen und der Stapel (ST1) mit der Unterseite auf einem Substrat (SUB) angeordnet ist und das Substrat (SUB) ein Halbleitermaterial umfasst.

2. Stapelförmige Halbleiterstruktur (HL) nach Anspruch 1, **dadurch gekennzeichnet, dass** zwischen dem Substrat und der Unterseite des Stapels (ST1), um einen monolithischen Verbund zwischen der Unterseite des Stapel und der Oberseite des Substrats (SUB) zu erzielen, eine Zwischenschicht (ZW) angeordnet ist und die Zwischenschicht (ZW) eine Nukleationsschicht und / oder eine Pufferschicht umfasst.

3. Stapelförmige Halbleiterstruktur (HL) nach Anspruch 1 oder Anspruch 2, **dadurch gekennzeichnet, dass** die Auftrittsfläche (UAF) der Hauptstufe (STU) an der Oberseite des Substrats (SUB) oder in dem Substrat (SUB) oder auf der Oberseite der Zwischenschicht (ZW) oder in der Zwischenschicht (ZW) ausgebildet ist.

4. Stapelförmige Halbleiterstruktur (HL) nach einem der Ansprüche 1 bis 3, **dadurch gekennzeichnet, dass** die Normale der Seitenfläche des Stapels (ST1) im Vergleich zu der Normale der Auftrittsfläche (AUF) in einen Winkelbereich zwischen 75° und 115° oder zwischen einem Winkelbereich zwischen 95° und 105° liegt.

5. Stapelförmige Halbleiterstruktur (HL) nach einem der Ansprüche 1 bis 4, **dadurch gekennzeichnet, dass** die Auftrittsfläche (AUF) der Hauptstufe (STU) plan ausgebildet ist und / oder die Auftrittsfläche (AUF) umlaufend eine Tiefenunterschied von kleiner als eine Faktor 4 oder keinen Unterschied in der Tiefe aufweist.

6. Stapelförmige Halbleiterstruktur (HL) nach einem der Ansprüche 1 bis 5, **dadurch gekennzeichnet, dass** an der Seitenfläche des Stapels (ST1) zwischen zwei unmittelbar aufeinanderfolgenden Halbleiterschichten Nebenstufen (NSTU) mit einer Stufentiefe kleiner als 5 µm ausgebildet sind.

7. Stapelförmige Halbleiterstruktur (HL) nach einem der Ansprüche 1 bis 6, **dadurch gekennzeichnet, dass** die Halbleiterdioden (D1, D2, D3, D4) eine Teilspannung aufweisen und die Abweichung der Teilspannung zwischen den Halbleiterdioden (D1, D2, D3, D4) kleiner als 10% ist.

8. Stapelförmige Halbleiterstruktur (HL) nach einem der Ansprüche 1 bis 7, **dadurch gekennzeichnet, dass** die Halbleiterdioden (D1, D2, D3, D4, D5) jeweils das gleiche Halbleitermaterial aufweisen.

9. Stapelförmige Halbleiterstruktur (HL) nach einem der Ansprüche 1 bis 8, **dadurch gekennzeichnet, dass** der Stapel (ST1) eine Grundfläche kleiner als 4 mm² oder kleiner als 2 mm² aufweist.

10. Stapelförmige Halbleiterstruktur (HL) nach einem der Ansprüche 1 bis 9, **dadurch gekennzeichnet, dass** die Grundfläche des Stapels (ST1) viereckig oder kreisförmig ausgebildet ist.

11. Stapelförmige Halbleiterstruktur (HL) nach einem der Ansprüche 1 bis 10, **dadurch gekennzeichnet, dass** auf der Oberseite des Stapels (ST1) ein erster Anschlusskontakt (K1) als ein umlaufender erster Metallkontakt (K1) in der Nähe des Randes (R) oder als eine einzelne Kontaktfläche (K1) an dem Rand (R) ausgebildet ist.

12. Stapelförmige Halbleiterstruktur (HL) nach einem der Ansprüche 1 bis 11, **dadurch gekennzeichnet, dass** auf der Unterseite des Substrats (SUB) ein zweiter Anschlusskontakt (K2) ausgebildet ist.

13. Stapelförmige Halbleiterstruktur (HL) nach einem der Ansprüche 1 bis 12, **dadurch gekennzeichnet, dass** der Stapel (ST1) III-V Materialien umfasst oder aus III-V Materialien besteht.

14. Stapelförmige Halbleiterstruktur (HL) nach einem der Ansprüche 1 bis 13, **dadurch gekennzeichnet, dass** das Substrat Germanium oder Galliumarsenid umfasst.
